# EUROPEAN PATENT APPLICATION

(11) **EP 4 844 761 A1**
(43) Date of publication of application: **25.11.2026**
(21) Application number: 25221626.2
(22) Date of filing: 09.12.2025
(51) Int. Cl.: G11C 7/10, G11C 7/22, G11C 16/26, G11C 16/32

(54) **DATA OUTPUT CIRCUIT, SEMICONDUCTOR MEMORY APPARATUS, AND MEMORY SYSTEM**

(30) Priority: 21.05.2025 KR 20250066217
(71) Applicant: SK hynix Inc., Bubal-eub Icheon-si Gyeonggi-do 17336 (KR)
(72) Inventor: CHAE, Kyeong Min, 17336 Icheon-si, Gyeonggi-do (KR)
(74) Representative: Isarpatent

(57) **Abstract**

A data output circuit includes a transmission clock generation circuit, a data alignment circuit, a transmission circuit, and a data output control circuit. The transmission clock generation circuit receives warm-up information and an external clock signal and outputs a plurality of transmission clock signals, wherein the warm-up information indicates a number of cycles included in a warm-up cycle operation. The data alignment circuit receives read data, the external clock signal, and the warm-up information and outputs a plurality of alignment data. The transmission circuit receives the plurality of transmission clock signals and a plurality of masked alignment data and outputs transmission data and a data strobe signal. The data output control circuit fixes the plurality of masked alignment data to a predetermined logic level during a time interval corresponding to the warm-up cycle by controlling the plurality of alignment data using a plurality of mask control signals generated according to the external clock signal and the warm-up information.

## Description

### BACKGROUND

### 1.TECHNICAL FIELD

Various embodiments generally relate to a semiconductor circuit, and more particularly, to a data output circuit, a semiconductor memory apparatus, and a memory system including the data output circuit.

### 2. RELATED ART

A semiconductor apparatus, such as a semiconductor memory apparatus, may store data provided from an external source in a memory region and may output data stored in the memory region to an external semiconductor memory apparatus in response to receiving an external request including a read command.

As the data exchange speed between a semiconductor memory apparatus and an external apparatus increases, a signal integrity issue has emerged. A signal integrity issue caused by an initial channel effect during high-speed clock toggling may determine the performance of the semiconductor memory apparatus. Accordingly, the semiconductor memory apparatus supports a warm-up cycle operation that identifies a portion of an external clock signal as a dummy signal to prevent a signal integrity issue caused by an initial clock toggle operation. In addition, the semiconductor memory apparatus supports a decision feedback equalization (DFE) function to ensure operational reliability during high-speed operation, and the decision feedback equalization function is related to the warm-up cycle operation.

### SUMMARY

**In** an embodiment, a data output circuit may include a transmission clock generation circuit, a data alignment circuit, a transmission circuit, and a data output control circuit. The transmission clock generation circuit may be configured to receive warm-up information and an external clock signal and may be configured to output a plurality of transmission clock signals, wherein the warm-up information indicates a number of cycles included in a warm-up cycle operation. The data alignment circuit may be configured to receive read data, the external clock signal, and the warm-up information and may be configured to output a plurality of alignment data. The transmission circuit may be configured to receive the plurality of transmission clock signals and a plurality of masked alignment data and may be configured to output transmission data and a data strobe signal. The data output control circuit may be configured to fix the plurality of masked alignment data to a predetermined logic level during a time interval corresponding to the warm-up cycle by controlling the plurality of alignment data using a plurality of mask control signals generated according to the external clock signal and the warm-up information.

In an embodiment, a semiconductor memory apparatus may include a memory cell array, an input/output pad circuit, a plurality of page buffers, and a data input/output circuit. The input/output pad circuit may include a plurality of pads configured to receive a command, an address, and an external clock signal, and configured to receive and output transmission data and a data strobe signal. The plurality of page buffers may be coupled to the memory cell array. The data input/output circuit is coupled between the plurality of page buffers and the input/output pad circuit, and data input/output circuit may be configured to generate a plurality of mask control signals by combining and shifting multi-phase clock signals, which are generated based on the external clock signal, in different sequences according to a warm-up cycle defined by warm-up information, and may be configured to fix the transmission data to a predetermined logic level independent of read data during a time interval corresponding to the warm-up cycle according to the plurality of mask control signals.

In an embodiment, a memory system may include a semiconductor memory apparatus and a controller. The semiconductor memory apparatus may include a first receiving circuit configured to operate in a decision feedback equalization scheme and configured to output transmission data and a data strobe signal according to a read command. The controller may include a second receiving circuit configured to operate in the decision feedback equalization scheme and configured to provide an external clock signal and the read command to the semiconductor memory apparatus. The semiconductor memory apparatus may be configured to generate read data according to the read command, may be configured to generate a plurality of mask control signals by combining and shifting multi-phase clock signals, which are generated according to the external clock signal, in different sequences based on a warm-up cycle defined by warm-up information, and may be configured to fix the transmission data to a predetermined logic level independent of the read data during a time interval corresponding to the warm-up cycle according to the plurality of mask control signals.

### BRIEF DESCRIPTION OF THE DRAWINGS

FIG. 1 is a diagram illustrating a configuration of a data output circuit, according to an embodiment of the present disclosure.
FIG. 2A is a diagram illustrating a configuration of a transmission clock generation circuit of FIG. 1.
FIG. 2B is a truth table for explaining an operation of a switching control signal generation circuit of FIG. 2A.
FIG. 3A is a diagram illustrating a configuration of an alignment clock generation circuit of FIG. 1.
FIG. 3B is a truth table for explaining an operation of a shift control signal generation circuit of FIG. 3A.
FIG. 4 is a diagram illustrating a configuration of a first clock control circuit of FIG. 3A.
FIG. 5 is a diagram illustrating a configuration of a transmission circuit of FIG. 1.
FIG. 6 is a timing diagram illustrating an operation of a data output circuit, according to an embodiment of the present disclosure.
FIG. 7 is a diagram illustrating a configuration of a data output circuit, according to an embodiment of the present disclosure.
FIG. 8 is a diagram illustrating a configuration of an alignment clock generation circuit of FIG. 7.
FIG. 9A is a diagram illustrating a configuration of a preliminary mask control signal generation circuit of FIG. 7.
FIG. 9B is a truth table for explaining an operation of a switching control signal generation circuit of FIG. 9A.
FIG. 10 is a diagram illustrating a configuration of a mask control signal generation circuit of FIG. 7.
FIG. 11 is a diagram illustrating a configuration of a data mask circuit of FIG. 7.
FIGS. 12, 13, and 14 are timing diagrams illustrating operations of a data output circuit, according to an embodiment of the present disclosure.
FIG. 15 is a diagram illustrating a configuration of a semiconductor memory apparatus, according to an embodiment of the present disclosure.
FIG. 16 is a diagram illustrating a configuration of a memory system, according to an embodiment of the present disclosure.

### DETAILED DESCRIPTION

Various embodiments can improve signal transmission and reception performance because they can appropriately control data according to a signal reception method based on equalization and a warm-up cycle operation method.

Hereinafter, some embodiments of the present disclosure are described in more detail with reference to the accompanying drawings.

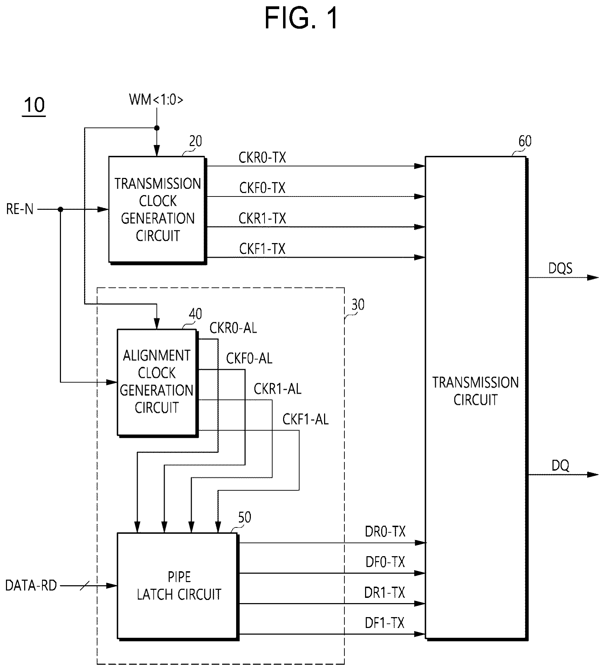

FIG. 1 is a diagram illustrating a configuration of a data output circuit 10, according to an embodiment of the present disclosure.

Referring to FIG. 1, the data output circuit 10 may include a transmission clock generation circuit 20, a data alignment circuit 30, and a transmission circuit 60.

The transmission clock generation circuit 20 may receive an external clock signal RE-N and warm-up information WM<1:0>, and may output a plurality of transmission clock signals CKR0-TX, CKFO-TX, CKR1-TX, and CKF1-TX. The external clock signal RE-N may be provided from outside a semiconductor memory apparatus, and may be a signal received through a receiving circuit inside the semiconductor memory apparatus. The warm-up information WM<1:0> is information for a warm-up cycle operation and may include information on the number of cycles during which the warm-up cycle operation is performed. Hereinafter, among the plurality of transmission clock signals CKR0-TX, CKFO-TX, CKR1-TX, and CKF1-TX, CKR0-TX is referred to as a first transmission clock signal, CKF0-TX as a second transmission clock signal, CKR1-TX as a third transmission clock signal, and CKF1-TX as a fourth transmission clock signal.

The data alignment circuit 30 may receive read data DATA-RD, the external clock signal RE-N, and the warm-up information WM<1:0>, and may output a plurality of alignment data DRO-TX, DFO-TX, DR1-TX, and DF1-TX. The read data DATA-RD may include data output from a memory region of the semiconductor memory apparatus including the data output circuit 10, in response to an external request such as a read command. Among the plurality of alignment data DRO-TX, DF0-TX, DR1-TX, and DF1-TX, DR0-TX is referred to as first alignment data, DF0-TX as second alignment data, DR1-TX as third alignment data, and DF1-TX as fourth alignment data.

The data alignment circuit 30 may include an alignment clock generation circuit 40 and a pipe latch circuit 50. The alignment clock generation circuit 40 may receive the external clock signal RE-N and the warm-up information WM<1:0>, and may generate a plurality of alignment clock signals CKRO-AL, CKFO-AL, CKR1-AL, and CKF1-AL. Among the plurality of alignment clock signals CKRO-AL, CKFO-AL, CKR1-AL, and CKF1-AL, CKR0-AL is referred to as a first alignment clock signal, CKF0-AL as a second alignment clock signal, CKR1-AL as a third alignment clock signal, and CKF1-AL as a fourth alignment clock signal.

The pipe latch circuit 50 may deserialize the read data DATA-RD through pipelining to generate deserialized data, and may output the deserialized data as the plurality of alignment data DRO-TX, DFO-TX, DR1-TX, and DF1-TX by latching the deserialized data according to the plurality of alignment clock signals CKRO-AL, CKFO-AL, CKR1-AL, and CKF1-AL.

The transmission circuit 60 may receive the plurality of transmission clock signals CKR0-TX, CKFO-TX, CKR1-TX, and CKF1-TX and the plurality of alignment data DRO-TX, DFO-TX, DR1-TX, and DF1-TX, and may output transmission data DQ and a data strobe signal DQS.

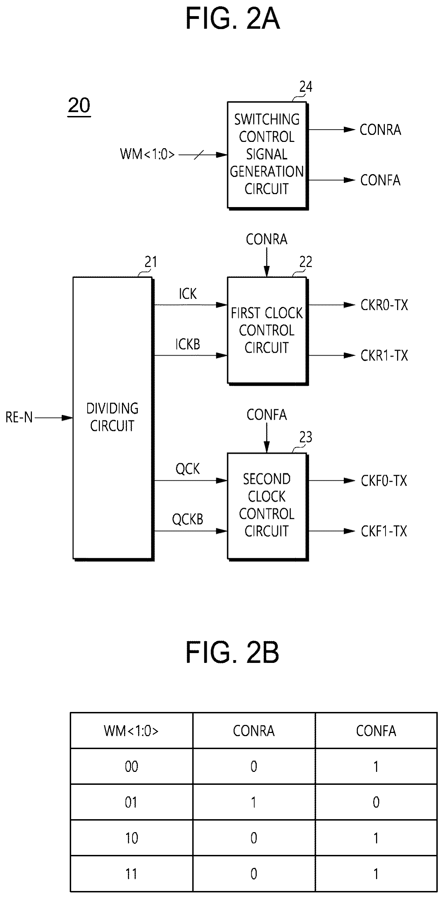

FIG. 2A is a diagram illustrating a configuration of the transmission clock generation circuit 20 of FIG. 1, and FIG. 2B is a truth table for explaining an operation of a switching control signal generation circuit 24 of FIG. 2A.

Referring to FIG. 2A, the transmission clock generation circuit 20 may include a dividing circuit 21, a first clock control circuit 22, a second clock control circuit 23, and the switching control signal generation circuit 24.

The dividing circuit 21 may receive the external clock signal RE-N, and may output multi-phase clock signals ICK, QCK, ICKB, and QCKB. The dividing circuit 21 may divide the external clock signal RE-N and divide its phase to generate the multi-phase clock signals ICK, QCK, ICKB, and QCKB. The multi-phase clock signals ICK, QCK, ICKB, and QCKB may have a predetermined phase difference in sequence (e.g., 90°). The word "predetermined" as used herein with respect to a parameter, such as a predetermined time, time interval, or voltage level, means that a value for the parameter is determined prior to the parameter being used in a process or algorithm. For some embodiments, the value for the parameter is determined before the process or algorithm begins. In other embodiments, the value for the parameter is determined during the process or algorithm but before the parameter is used in the process or algorithm. Hereinafter, among the multi-phase clock signals ICK, QCK, ICKB, and QCKB, ICK is referred to as a first phase clock signal, QCK as a second phase clock signal, ICKB as a third phase clock signal, and QCKB as a fourth phase clock signal.

The first clock control circuit 22 may receive the first phase clock signal ICK, the third phase clock signal ICKB, and a first switching control signal CONRA, and may output the first transmission clock signal CKR0-TX and the third transmission clock signal CKR1-TX.

The first clock control circuit 22 may output the first phase clock signal ICK as the third transmission clock signal CKR1-TX and output the third phase clock signal ICKB as the first transmission clock signal CKR0-TX when the first switching control signal CONRA is at a first logic level (e.g., a logic high level). The first clock control circuit 22 may output the first phase clock signal ICK as the first transmission clock signal CKR0-TX and output the third phase clock signal ICKB as the third transmission clock signal CKR1-TX when the first switching control signal CONRA is at a second logic level (e.g., a logic low level).

The second clock control circuit 23 may receive the second phase clock signal QCK, the fourth phase clock signal QCKB, and a second switching control signal CONFA, and may output the second transmission clock signal CKF0-TX and the fourth transmission clock signal CKF1-TX.

The second clock control circuit 23 may output the second phase clock signal QCK as the fourth transmission clock signal CKF1-TX and output the fourth phase clock signal QCKB as the second transmission clock signal CKF0-TX when the second switching control signal CONFA is at a logic high level. The second clock control circuit 23 may output the second phase clock signal QCK as the second transmission clock signal CKF0-TX and output the fourth phase clock signal QCKB as the fourth transmission clock signal CKF1-TX when the second switching control signal CONFA is at a logic low level.

The switching control signal generation circuit 24 may receive the warm-up information WM<1:0> and may output the switching control signals CONRA and CONFA. Referring to FIG. 2B, the switching control signal generation circuit 24 may be configured to generate the switching control signals CONRA and CONFA as '01', '10', '01', and '01' respectively when the warm-up information WM<1:0> is '00' (no warm-up cycle), '01' (warm-up 1 cycle), '10' (warm-up 2 cycles), and '11' (warm-up 4 cycles).

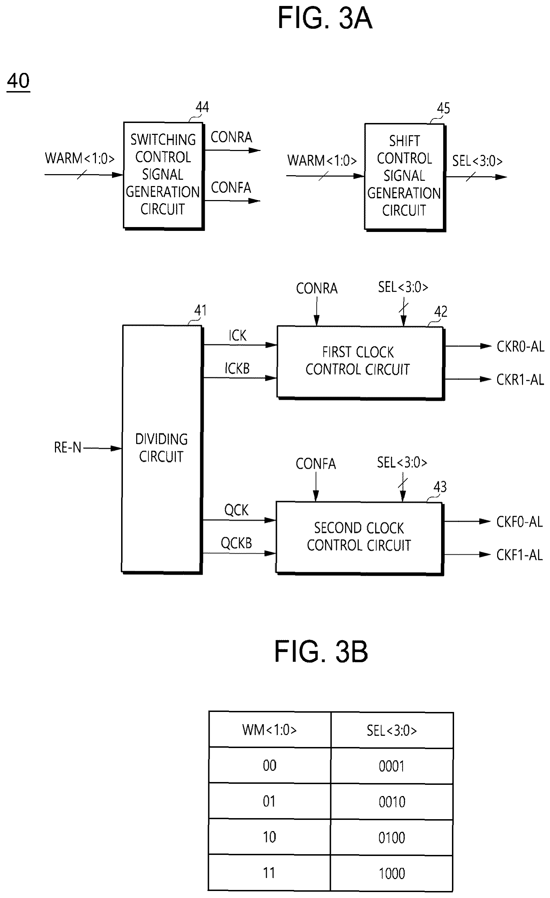

FIG. 3A is a diagram illustrating a configuration of the alignment clock generation circuit 40 of FIG. 1, and FIG. 3B is a truth table illustrating an operation of a shift control signal generation circuit 45 of FIG. 3A.

Referring to FIG. 3A, the alignment clock generation circuit 40 may include a dividing circuit 41, a first clock control circuit 42, a second clock control circuit 43, a switching control signal generation circuit 44, and a shift control signal generation circuit 45.

The dividing circuit 41 may receive the external clock signal RE-N, and may output multi-phase clock signals ICK, QCK, ICKB, and QCKB. The dividing circuit 41 may divide the external clock signal RE-N and divide its phase to generate the multi-phase clock signals ICK, QCK, ICKB, and QCKB.

The first clock control circuit 42 may receive the first phase clock signal ICK, the third phase clock signal ICKB, a first switching control signal CONRA, and a shift control signal SEL<3:0>, and may output the first alignment clock signal CKR0-AL and the third alignment clock signal CKR1-AL.

The first clock control circuit 42 may switch signal paths of the first phase clock signal ICK and the third phase clock signal ICKB based on the first switching control signal CONRA, and may generate a plurality of first shifting signals and a plurality of second shifting signals by shifting the switched signals. Then, the first clock control circuit 42 may generate the first alignment clock signal CKR0-AL and the third alignment clock signal CKR1-AL by selecting one signal from each of the plurality of first and second shifting signals according to the shift control signal SEL<3:0>.

The second clock control circuit 43 may receive the second phase clock signal QCK, the fourth phase clock signal QCKB, a second switching control signal CONFA, and the shift control signal SEL<3:0>, and may output the second alignment clock signal CKF0-AL and the fourth alignment clock signal CKF1-AL.

The second clock control circuit 43 may switch signal paths of the second phase clock signal QCK and the fourth phase clock signal QCKB based on the second switching control signal CONFA, and may generate a plurality of first shifting signals and a plurality of second shifting signals by shifting the switched signals. Then, the second clock control circuit 43 may generate the second alignment clock signal CKF0-AL and the fourth alignment clock signal CKF1-AL by selecting one signal from each of the plurality of first and second shifting signals according to the shift control signal SEL<3:0>.

The switching control signal generation circuit 44 may receive the warm-up information WM<1:0> (i.e., WARM<1:0>) and may output the switching control signals CONRA and CONFA. The switching control signal generation circuit 44 may be configured similarly to the switching control signal generation circuit 24 described with reference to FIGS. 2A and 2B.

The shift control signal generation circuit 45 may receive the warm-up information WM<1:0> and may output the shift control signal SEL<3:0>.

Referring to FIG. 3B, the shift control signal generation circuit 45 may be configured to generate the shift control signal SEL<3:0> as '0001', '0010', '0100', and '1000', respectively, when the warm-up information WM<1:0> is '00' (no warm-up cycle), '01' (warm-up 1 cycle), '10' (warm-up 2 cycles), and '11' (warm-up 4 cycles).

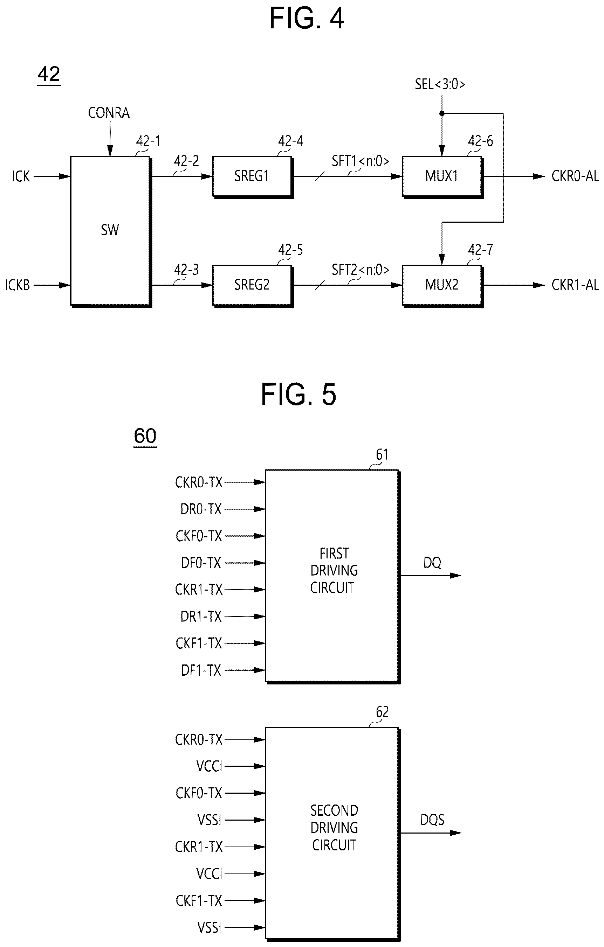

FIG. 4 is a diagram illustrating a configuration of the first clock control circuit 42 of FIG. 3A.

Referring to FIG. 4, the first clock control circuit 42 may include a switching circuit SW 42-1, a first shift register SREG1 42-4, a second shift register SREG2 42-5, a first multiplexer MUX1 42-6, and a second multiplexer MUX2 42-7.

The switching circuit SW 42-1 may output the first phase clock signal ICK to a second signal path 42-3 and output the third phase clock signal ICKB to a first signal path 42-2 when the first switching control signal CONRA is at a logic high level. The switching circuit SW 42-1 may output the first phase clock signal ICK to the first signal path 42-2 and output the third phase clock signal ICKB to the second signal path 42-3 when the first switching control signal CONRA is at a logic low level.

The first shift register 42-4 may shift a signal transmitted through the first signal path 42-2 and may output a plurality of first shifting signals SFT1<n:0>.

The first shift register 42-4 may sequentially shift the signal transmitted through the first signal path 42-2 according to clock pulses of the external clock signal RE-N or an internal clock signal generated based on the external clock signal RE-N, thereby generating the plurality of first shifting signals SFT1<n:0>. The first shifting signal SFT1<0> may be a bypassed version of the signal transmitted through the first signal path 42-2. For example, the first shift register 42-4 may just pass the signal received through the first signal path 42-2 as the first shifting signal SFT1<0>. Other first shifting signals SFT1<n:1> may be signals sequentially shifted from the signal transmitted through the first signal path 42-2 according to the clock pulses of the external clock signal RE-N or the internal clock signal.

The second shift register 42-5 may shift a signal transmitted through the second signal path 42-3 and may output a plurality of second shifting signals SFT2<n:0>. The second shift register 42-5 may be configured similarly to the first shift register 42-4 and may operate in a similar manner.

The first multiplexer 42-6 may select one from the plurality of first shifting signals SFT1<n:0> based on the shift control signal SEL<3:0>, and may output the selected signal as the first alignment clock signal CKR0-AL.

The second multiplexer 42-7 may select one from the plurality of second shifting signals SFT2<n:0> based on the shift control signal SEL<3:0>, and may output the selected signal as the third alignment clock signal CKR1-AL.

The operation of the first clock control circuit 42 configured as described above is now explained.

In an embodiment, when the warm-up information WM<1:0> is '00' indicating no warm-up cycle, the switching control signals CONRA and CONFA are '01', and the shift control signal SEL<3:0> is '0001'. In this case, the first clock control circuit 42 may output a bypassed signal of the first phase clock signal ICK as the first alignment clock signal CKR0-AL, and may output a bypassed signal of the third phase clock signal ICKB as the third alignment clock signal CKR1-AL.

In an embodiment, when the warm-up information WM<1:0> is '01' indicating warm-up for 1 cycle, the switching control signals CONRA and CONFA are '10', and the shift control signal SEL<3:0> is '0010'. In this case, the first clock control circuit 42 may output the first shifting signal SFT1<1>, which is generated by shifting the third phase clock signal ICKB, as the first alignment clock signal CKRO-AL, and may output the second shifting signal SFT2<1>, which is generated by shifting the first phase clock signal ICK, as the third alignment clock signal CKR1-AL.

FIG. 5 is a diagram illustrating a configuration of the transmission circuit 60 of FIG. 1.

Referring to FIG. 5, the transmission circuit 60 may include a first driving circuit 61 and a second driving circuit 62.

The first driving circuit 61 may receive the plurality of alignment data DRO-TX, DFO-TX, DR1-TX, and DF1-TX and the plurality of transmission clock signals CKR0-TX, CKFO-TX, CKR1-TX, and CKF1-TX, and may output the transmission data DQ. The first driving circuit 61 may generate the transmission data DQ by pulling up to a power supply voltage level or pulling down to a ground voltage level based on logic levels of the plurality of alignment data DRO-TX, DFO-TX, DR1-TX, and DF1-TX, at rising edges of each of the plurality of transmission clock signals CKR0-TX, CKFO-TX, CKR1-TX, and CKF1-TX.

The second driving circuit 62 may receive the plurality of transmission clock signals CKR0-TX, CKFO-TX, CKR1-TX, and CKF1-TX, a power supply voltage VCCI, and a ground voltage VSSI, and may output the data strobe signal DQS. The second driving circuit 62 may generate the data strobe signal DQS by pulling up to the power supply voltage VCCI or pulling down to the ground voltage VSSI, at rising edges of each of the plurality of transmission clock signals CKR0-TX, CKFO-TX, CKR1-TX, and CKF1-TX.

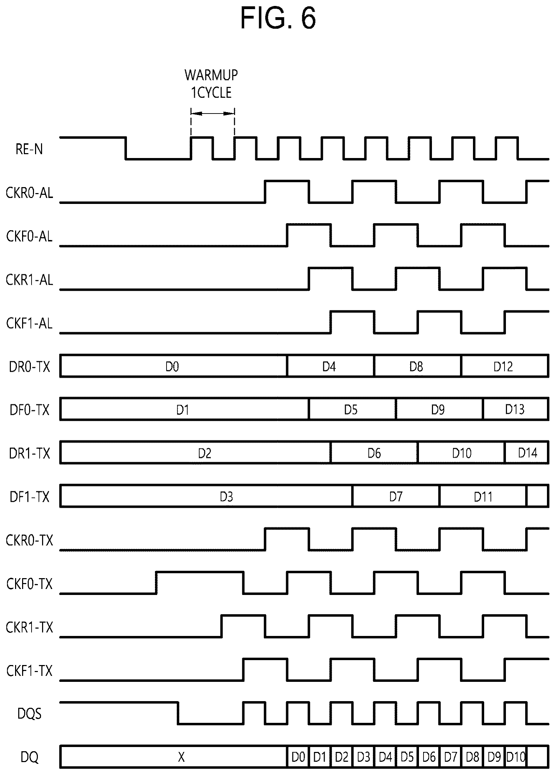

FIG. 6 is a timing diagram illustrating an operation of the data output circuit 10, according to an embodiment of the present disclosure. It is assumed that the warm-up information WM<1:0> indicates warm-up for 1 cycle, i.e., '01'.

Because the warm-up information WM<1:0> is '01', the switching control signals CONRA and CONFA are generated as '10', and the shift control signal SEL<3:0> is generated as '0010'.

Based on a falling edge of a second pulse after a preamble of the external clock signal RE-N, the plurality of alignment clock signals CKRO-AL, CKF0-AL, CKR1-AL, and CKF1-AL are generated according to the switching control signals CONRA and CONFA and the shift control signal SEL<3:0>.

The read data DATA-RD is latched and aligned according to the plurality of alignment clock signals CKRO-AL, CKFO-AL, CKR1-AL, and CKF1-AL, and the plurality of alignment data DRO-TX, DFO-TX, DR1-TX, and DF1-TX are generated.

The data DQ and the data strobe signal DQS are generated according to the plurality of transmission clock signals CKR0-TX, CKFO-TX, CKR1-TX, and CKF1-TX, which are generated to match the switching control signals CONRA and CONFA.

After a normal pulse cycle of the data strobe signal DQS elapses following its preamble-that is, after the time corresponding to one warm-up cycle has elapsed-normal data D0, D1, D2, ... are sequentially output according to the plurality of transmission clock signals CKR0-TX, CKFO-TX, CKR1-TX, and CKF1-TX.

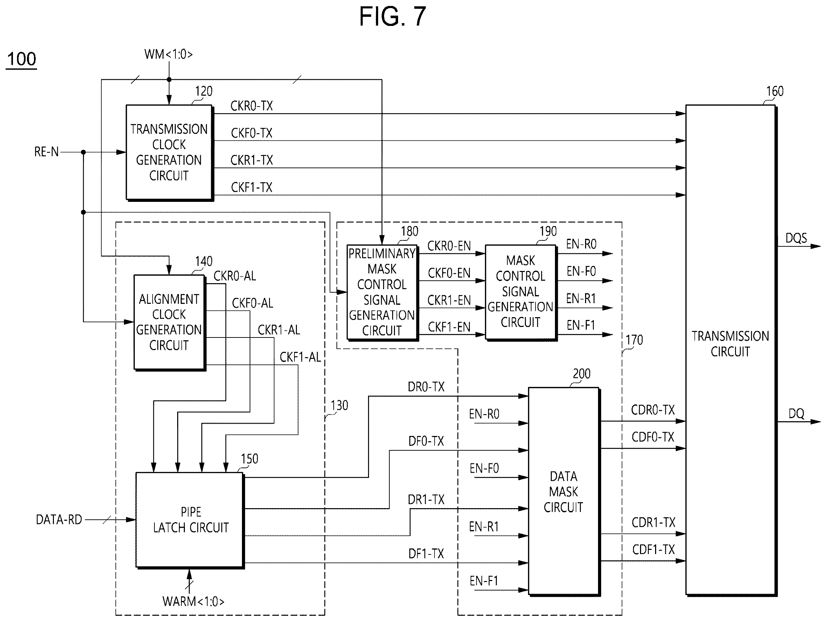

FIG. 7 is a diagram illustrating a configuration of a data output circuit 100, according to an embodiment of the present disclosure.

Referring to FIG. 7, the data output circuit 100 may include a transmission clock generation circuit 120, a data alignment circuit 130, a transmission circuit 160, and a data output control circuit 170.

The transmission clock generation circuit 120 may receive an external clock signal RE-N and warm-up information WM<1:0>, and may output a plurality of transmission clock signals CKR0-TX, CKFO-TX, CKR1-TX, and CKF1-TX. The transmission clock generation circuit 120 may be configured similarly to the transmission clock generation circuit 20 of FIG. 1.

The data alignment circuit 130 may receive read data DATA-RD, the external clock signal RE-N, and the warm-up information WM<1:0>, and may output a plurality of alignment data DRO-TX, DFO-TX, DR1-TX, and DF1-TX.

The data alignment circuit 130 may include an alignment clock generation circuit 140 and a pipeline latch circuit 150. The alignment clock generation circuit 140 may receive the external clock signal RE-N and the warm-up information WM<1:0>, and may output a plurality of alignment clock signals CKRO-AL, CKFO-AL, CKR1-AL, and CKF1-AL. The pipeline latch circuit 150 may deserialize the read data DATA-RD through pipeline processing to generate deserialized data, and may output the deserialized data as a plurality of alignment data DRO-TX, DFO-TX, DR1-TX, and DF1-TX by latching the deserialized data according to the plurality of alignment clock signals CKRO-AL, CKFO-AL, CKR1-AL, and CKF1-AL.

The transmission circuit 160 may receive the plurality of transmission clock signals CKR0-TX, CKFO-TX, CKR1-TX, and CKF1-TX and a plurality of masked alignment data CDR0-TX, CDFO-TX, CDR1-TX, and CDF1-TX, and may output transmission data DQ and a data strobe signal DQS. The transmission circuit 160 may be configured similarly to the transmission circuit 60 of FIG. 1.

The data output control circuit 170 may receive the external clock signal RE-N, the warm-up information WM<1:0>, and the plurality of alignment data DRO-TX, DFO-TX, DR1-TX, and DF1-TX, and may output the plurality of masked alignment data CDR0-TX, CDFO-TX, CDR1-TX, and CDF1-TX. Among the plurality of masked alignment data, CDR0-TX, CDFO-TX, CDR1-TX, and CDF1-TX are referred to as first, second, third, and fourth masked alignment data, respectively.

The data output control circuit 170 may generate the plurality of masked alignment data CDR0-TX, CDFO-TX, CDR1-TX, and CDF1-TX fixed at a predetermined logic level for a duration corresponding to a warm-up cycle by controlling the plurality of alignment data DRO-TX, DFO-TX, DR1-TX, and DF1-TX using a plurality of mask control signals EN-R0, EN-FO, EN-R1, and EN-F1, which are generated based on the external clock signal RE-N and the warm-up information WM<1:0>.

The data output control circuit 170 may include a preliminary mask control signal generation circuit 180, a mask control signal generation circuit 190, and a data mask circuit 200.

The preliminary mask control signal generation circuit 180 may receive the external clock signal RE-N and the warm-up information WM<1:0>, and may output a plurality of preliminary mask control signals CKRO-EN, CKF0-EN, CKR1-EN, and CKF1-EN. The preliminary mask control signal generation circuit 180 may adjust a combination sequence and shifting value of multi-phase clock signals generated from the external clock signal RE-N based on the warm-up information WM<1:0> to generate the plurality of preliminary mask control signals CKRO-EN, CKF0-EN, CKR1-EN, and CKF1-EN. Among these, CKRO-EN, CKF0-EN, CKR1-EN, and CKF1-EN are referred to as a first, a second, a third, and a fourth preliminary mask control signal, respectively.

The mask control signal generation circuit 190 may receive the plurality of preliminary mask control signals CKRO-EN, CKF0-EN, CKR1-EN, and CKF1-EN, and may output the plurality of mask control signals EN-R0, EN-FO, EN-R1, and EN-F1. The mask control signal generation circuit 190 may output the plurality of mask control signals EN-R0, EN-FO, EN-R1, and EN-F1 by latching a power supply voltage VCCI according to the plurality of preliminary mask control signals CKRO-EN, CKF0-EN, CKR1-EN, and CKF1-EN. Among these, EN-R0, EN-FO, EN-R1, and EN-F1 are referred to as first, second, third, and fourth mask control signals, respectively.

The data mask circuit 200 may mask the plurality of alignment data DRO-TX, DFO-TX, DR1-TX, and DF1-TX using the plurality of mask control signals EN-R0, EN-FO, EN-R1, and EN-F1, and may fix the plurality of masked alignment data CDR0-TX, CDF0-TX, CDR1-TX, and CDF1-TX at a predetermined logic level (e.g., a logic low level).

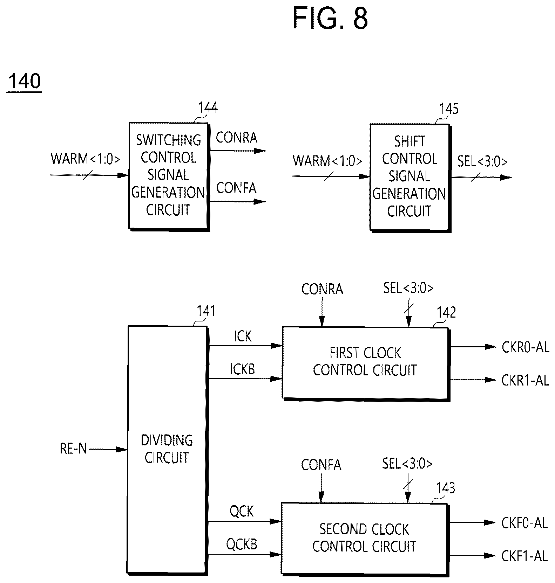

FIG. 8 is a diagram illustrating a configuration of the alignment clock generation circuit 140 of FIG. 7.

Referring to FIG. 8, the alignment clock generation circuit 140 may include a dividing circuit 141, a first clock control circuit 142, a second clock control circuit 143, a switching control signal generation circuit 144, and a shift control signal generation circuit 145.

The dividing circuit 141 may receive the external clock signal RE-N and may output multi-phase clock signals ICK, QCK, ICKB, and QCKB. The dividing circuit 141 may divide the external clock signal RE-N and divide its phase to generate the multi-phase clock signals ICK, QCK, ICKB, and QCKB.

The first clock control circuit 142 may receive a first phase clock signal ICK, a third phase clock signal ICKB, a first switching control signal CONRA, and a shift control signal SEL<3:0>, and may output the first alignment clock signal CKR0-AL and the third alignment clock signal CKR1-AL.

The first clock control circuit 142 may switch signal paths of the first phase clock signal ICK and the third phase clock signal ICKB according to the first switching control signal CONRA, and may generate a plurality of first shifting signals and a plurality of second shifting signals by shifting the switched signals. Then, the first clock control circuit 142 may generate the first alignment clock signal CKR0-AL and the third alignment clock signal CKR1-AL by selecting one signal from each of the plurality of first and second shifting signals according to the shift control signal SEL<3:0>.

The second clock control circuit 143 may receive a second phase clock signal QCK, a fourth phase clock signal QCKB, a second switching control signal CONFA, and the shift control signal SEL<3:0>, and may output the second alignment clock signal CKF0-AL and the fourth alignment clock signal CKF1-AL.

The second clock control circuit 143 may switch signal paths of the second phase clock signal QCK and the fourth phase clock signal QCKB according to the second switching control signal CONFA, and may generate a plurality of first shifting signals and a plurality of second shifting signals by shifting the switched signals. Then, the second clock control circuit 143 may generate the second alignment clock signal CKF0-AL and the fourth alignment clock signal CKF1-AL by selecting one signal from each of the plurality of first and second shifting signals according to the shift control signal SEL<3:0>.

The switching control signal generation circuit 144 may receive the warm-up information WM<1:0> and may output the switching control signals CONRA and CONFA. The switching control signal generation circuit 144 may be configured similarly to the switching control signal generation circuit 24 described with reference to FIGS. 2A and 2B.

The shift control signal generation circuit 145 may receive the warm-up information WM<1:0> and may output the shift control signal SEL<3:0>. The shift control signal generation circuit 145 may be configured similarly to the shift control signal generation circuit 45 described with reference to FIGS. 3A and 3B.

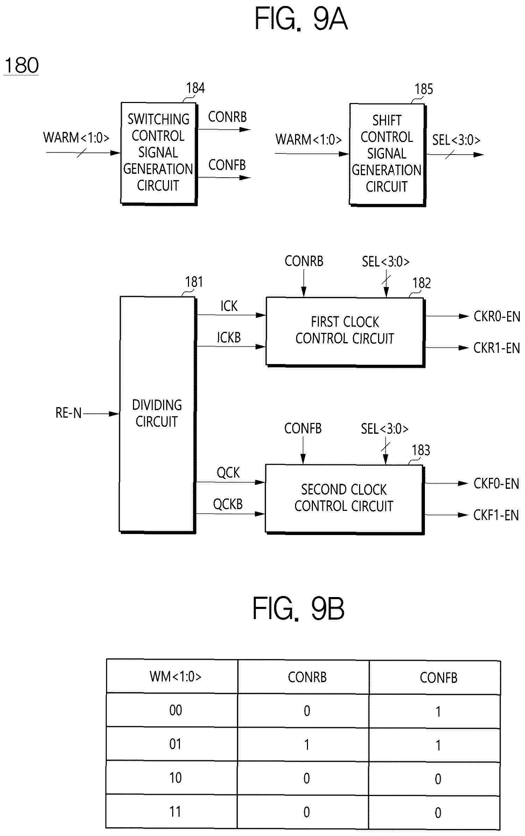

FIG. 9A is a diagram illustrating a configuration of the preliminary mask control signal generation circuit 180 of FIG. 7, and FIG. 9B is a truth table illustrating an operation of a switching control signal generation circuit 184 of FIG. 9A.

Referring to FIG. 9A, the preliminary mask control signal generation circuit 180 may include a dividing circuit 181, a first clock control circuit 182, a second clock control circuit 183, a switching control signal generation circuit 184, and a shift control signal generation circuit 185.

The dividing circuit 181 may receive the external clock signal RE-N and may output multi-phase clock signals ICK, QCK, ICKB, and QCKB. The dividing circuit 181 may divide the external clock signal RE-N and divide its phase to generate the multi-phase clock signals ICK, QCK, ICKB, and QCKB.

The first clock control circuit 182 may receive the first phase clock signal ICK, the third phase clock signal ICKB, a switching control signal CONRB, and a shift control signal SEL<3:0>, and it may output the first preliminary mask control signal CKR0-EN and the third preliminary mask control signal CKR1-EN.

The first clock control circuit 182 may switch signal paths of the first phase clock signal ICK and the third phase clock signal ICKB according to the switching control signal CONRB, and it may generate a plurality of first shifting signals and a plurality of second shifting signals by shifting the switched signals. Then, the first clock control circuit 182 may generate the first preliminary mask control signal CKR0-EN and the third preliminary mask control signal CKR1-EN by selecting one signal from each of the plurality of first and second shifting signals according to the shift control signal SEL<3:0>.

The second clock control circuit 183 may receive the second phase clock signal QCK, the fourth phase clock signal QCKB, a switching control signal CONFB, and the shift control signal SEL<3:0>, and it may output the second preliminary mask control signal CKF0-EN and the fourth preliminary mask control signal CKF1-EN.

The second clock control circuit 183 may switch signal paths of the second phase clock signal QCK and the fourth phase clock signal QCKB according to the switching control signal CONFB, and it may generate a plurality of first shifting signals and a plurality of second shifting signals by shifting the switched signals. Then, the second clock control circuit 183 may generate the second preliminary mask control signal CKF0-EN and the fourth preliminary mask control signal CKF1-EN by selecting one signal from each of the plurality of first and second shifting signals according to the shift control signal SEL<3:0>.

The switching control signal generation circuit 184 may receive the warm-up information WM<1:0> and may output the switching control signals CONRB and CONFB.

The shift control signal generation circuit 185 may receive the warm-up information WM<1:0> and may output the shift control signal SEL<3:0>. The shift control signal generation circuit 185 may be configured similarly to the shift control signal generation circuit 45 described with reference to FIGS. 3A and 3B.

Referring to FIG. 9B, the switching control signal generation circuit 184 may be configured to generate the switching control signals CONRB and CONFB as '01', '11', '00', and '00' respectively when the warm-up information WM<1:0> is '00' (no warm-up cycle), '01' (warm-up 1 cycle), '10' (warm-up 2 cycles), and '11' (warm-up 4 cycles).

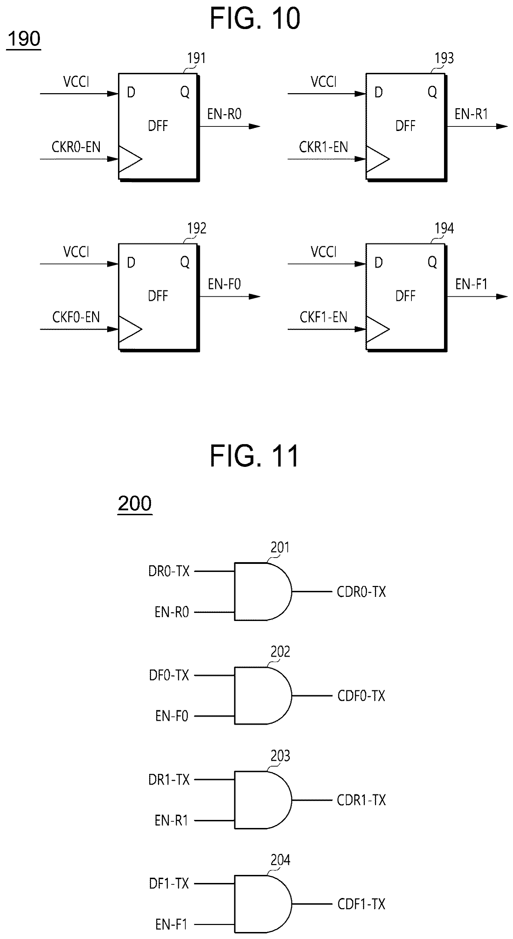

FIG. 10 is a diagram illustrating a configuration of the mask control signal generation circuit 190 of FIG. 7.

Referring to FIG. 10, the mask control signal generation circuit 190 may include a plurality of flip-flops 191 to 194. The first flip-flop 191 may latch the power supply voltage VCCI according to the first preliminary mask control signal CKR0-EN and may output the latched signal as the first mask control signal EN-R0. The second flip-flop 192 may latch the power supply voltage VCCI according to the second preliminary mask control signal CKF0-EN and may output the latched signal as the second mask control signal EN-F0. The third flip-flop 193 may latch the power supply voltage VCCI according to the third preliminary mask control signal CKR1-EN and may output the latched signal as the third mask control signal EN-R1. The fourth flip-flop 194 may latch the power supply voltage VCCI according to the fourth preliminary mask control signal CKF1-EN and may output the latched signal as the fourth mask control signal EN-F1.

FIG. 11 is a diagram illustrating a configuration of the data mask circuit 200 of FIG. 7.

Referring to FIG. 11, the data mask circuit 200 may include a plurality of logic gates 201 to 204. The first logic gate 201 may output a result obtained by performing an AND operation on the first mask control signal EN-R0 and the first alignment data DR0-TX as the first masked alignment data CDR0-TX. The second logic gate 202 may output a result obtained by performing an AND operation on the second mask control signal EN-F0 and the second alignment data DF0-TX as the second masked alignment data CDF0-TX. The third logic gate 203 may output a result obtained by performing an AND operation on the third mask control signal EN-R1 and the third alignment data DR1-TX as the third masked alignment data CDR1-TX. The fourth logic gate 204 may output a result obtained by performing an AND operation on the fourth mask control signal EN-F1 and the fourth alignment data DF1-TX as the fourth masked alignment data CDF1-TX.

The data mask circuit 200 may fix the plurality of masked alignment data CDR0-TX, CDFO-TX, CDR1-TX, and CDF1-TX at a logic low level regardless or independent of logic levels of the plurality of alignment data DRO-TX, DFO-TX, DR1-TX, and DF1-TX while the plurality of mask control signals EN-R0, EN-FO, EN-R1, and EN-F1 are at a logic low level. The data mask circuit 200 may output the plurality of alignment data DRO-TX, DFO-TX, DR1-TX, and DF1-TX as the plurality of masked alignment data CDR0-TX, CDFO-TX, CDR1-TX, and CDF1-TX by bypassing them while the plurality of mask control signals EN-R0, EN-FO, EN-R1, and EN-F1 are at a logic high level.

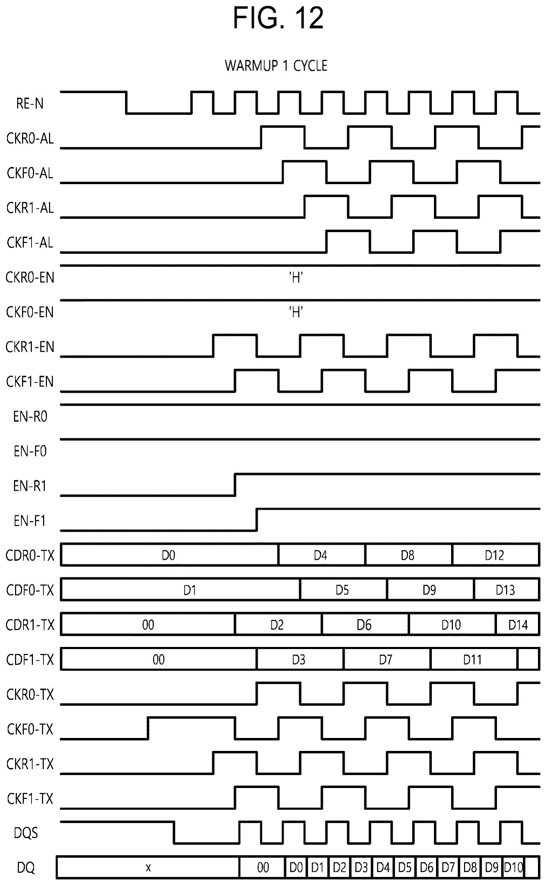

FIGS. 12 to 14 are timing diagrams illustrating operations of the data output circuit 100, according to an embodiment of the present disclosure.

First, the operation of the data output circuit 100 is described with reference to FIG. 12 for a case where the warm-up information WM<1:0> indicates warm-up 1 cycle, i.e., '01'.

In the alignment clock generation circuit 140, the switching control signals CONRA and CONFA are generated as '10' and the shift control signal SEL<3:0> is generated as '0010' according to the warm-up information WM<1:0> '01'. In the preliminary mask control signal generation circuit 180, the switching control signals CONRB and CONFB are generated as '11' and the shift control signal SEL<3:0> is generated as '0010' according to the warm-up information WM<1:0> '01'.

According to the switching control signals CONRA and CONFA and the shift control signal SEL<3:0>, the plurality of alignment clock signals CKRO-AL, CKFO-AL, CKR1-AL, and CKF1-AL may be generated based on a falling edge of a second pulse after a preamble of the external clock signal RE-N.

The read data DATA-RD is latched and aligned according to the plurality of alignment clock signals CKRO-AL, CKFO-AL, CKR1-AL, and CKF1-AL, and the plurality of alignment data DRO-TX, DFO-TX, DR1-TX, and DF1-TX is generated.

According to the switching control signals CONRB and CONFB and the shift control signal SEL<3:0>, the first and second preliminary mask control signals CKR0-EN and CKF0-EN remain at a logic high level, and the third and fourth preliminary mask control signals CKR1-EN and CKF1-EN remain at a logic low level and begin pulse generation at a timing earlier than the third and fourth alignment clock signals CKR1-AL and CKF1-AL, respectively. The third and fourth preliminary mask control signals CKR1-EN and CKF1-EN may be sequentially generated based on a falling edge of a first pulse after the preamble of the external clock signal RE-N.

The first and second mask control signals EN-R0 and EN-F0 remain at a logic high level, and the third and fourth mask control signals EN-R1 and EN-F1 remain at a logic low level and transition to a logic high level according to rising edges of the third and fourth preliminary mask control signals CKR1-EN and CKF1-EN.

The first and second masked alignment data CDR0-TX and CDF0-TX are generated as values D0 and D1 corresponding to the first and second alignment data DR0-TX and DFO-TX, respectively, according to the first and second mask control signals EN-R0 and EN-F0 at a logic high level.

Meanwhile, the third and fourth masked alignment data CDR1-TX and CDF1-TX are masked by the third and fourth mask control signals EN-R1 and EN-F1 at a logic low level and are maintained at '00' regardless or independent of the third and fourth alignment data DR1-TX and DF1-TX.

Subsequently, as the third and fourth mask control signals EN-R1 and EN-F1 transition to a logic high level, the third and fourth masked alignment data CDR1-TX and CDF1-TX are generated as values D2 and D3 corresponding to the third and fourth alignment data DR1-TX and DF1-TX, respectively.

The transmission data DQ and the data strobe signal DQS are generated according to the plurality of transmission clock signals CKR0-TX, CKFO-TX, CKR1-TX, and CKF1-TX, which are generated to match the switching control signals CONRA and CONFA.

The transmission data DQ remains at a logic low level for a duration corresponding to warm-up for 1 cycle, i.e., a single cycle of a normal pulse of the data strobe signal DQS after its preamble, due to a masking operation by the third and fourth mask control signals EN-R1 and EN-F1. Thereafter, normal data D0, D1, D2, ... are sequentially output according to the plurality of transmission clock signals CKR0-TX, CKF0-TX, CKR1-TX, and CKF1-TX.

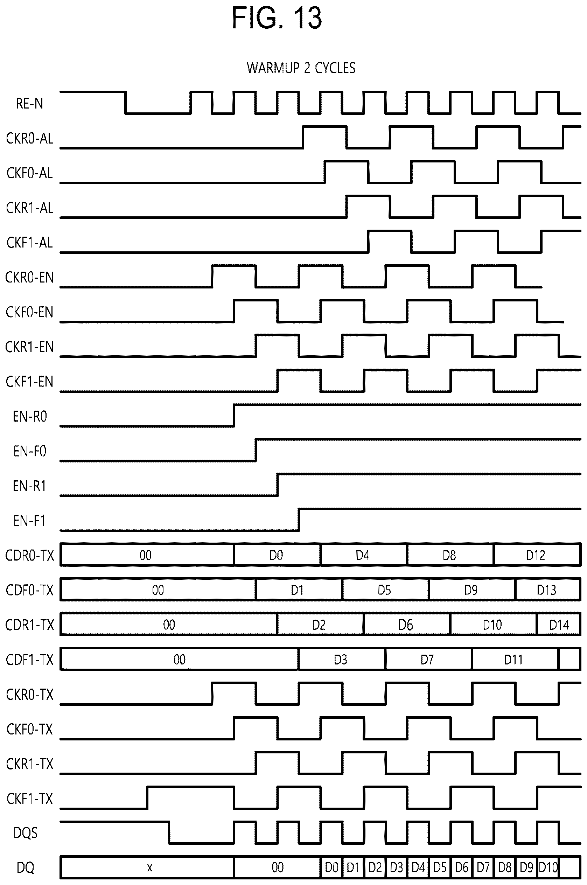

Next, the operation of the data output circuit 100 is described with reference to FIG. 13 for a case where the warm-up information WM<1:0> indicates warm-up for 2 cycles, i.e., '10'.

In the alignment clock generation circuit 140, the switching control signals CONRA and CONFA are generated as '01' and the shift control signal SEL<3:0> is generated as '0100' according to the warm-up information WM<1:0> '10'. In the preliminary mask control signal generation circuit 180, the switching control signals CONRB and CONFB are generated as '00' and the shift control signal SEL<3:0> is generated as '0100' according to the warm-up information WM<1:0> '10'.

According to the switching control signals CONRA and CONFA and the shift control signal SEL<3:0>, the plurality of alignment clock signals CKRO-AL, CKFO-AL, CKR1-AL, and CKF1-AL are generated based on a falling edge of a third pulse after a preamble of the external clock signal RE-N.

The read data DATA-RD is latched and aligned according to the plurality of alignment clock signals CKRO-AL, CKFO-AL, CKR1-AL, and CKF1-AL, and the plurality of alignment data DRO-TX, DFO-TX, DR1-TX, and DF1-TX is generated.

According to the switching control signals CONRB and CONFB and the shift control signal SEL<3:0>, the plurality of preliminary mask control signals CKRO-EN, CKF0-EN, CKR1-EN, and CKF1-EN are all maintained at a logic low level and begin pulse generation at a timing earlier than the plurality of alignment clock signals CKRO-AL, CKF0-AL, CKR1-AL, and CKF1-AL. The plurality of preliminary mask control signals CKRO-EN, CKF0-EN, CKR1-EN, and CKF1-EN may be sequentially generated based on a falling edge of a first pulse after the preamble of the external clock signal RE-N.

The plurality of mask control signals EN-R0, EN-FO, EN-R1, and EN-F1 remain at a logic low level and transition to a logic high level according to rising edges of the plurality of preliminary mask control signals CKRO-EN, CKF0-EN, CKR1-EN, and CKF1-EN.

The plurality of masked alignment data CDR0-TX, CDFO-TX, CDR1-TX, and CDF1-TX are masked by the plurality of mask control signals EN-R0, EN-F0, EN-R1, and EN-F1 at a logic low level and are maintained at '00' regardless or independent of the plurality of alignment data DRO-TX, DFO-TX, DR1-TX, and DF1-TX.

Subsequently, as the plurality of mask control signals EN-R0, EN-FO, EN-R1, and EN-F1 transition to a logic high level, the plurality of masked alignment data CDR0-TX, CDFO-TX, CDR1-TX, and CDF1-TX are generated as values D0, D1, D2, and D3 corresponding to the plurality of alignment data DRO-TX, DFO-TX, DR1-TX, and DF1-TX, respectively.

The transmission data DQ and the data strobe signal DQS are generated according to the plurality of transmission clock signals CKR0-TX, CKFO-TX, CKR1-TX, and CKF1-TX, which are generated to match the switching control signals CONRA and CONFA.

The transmission data DQ remains at a logic low level for a duration corresponding to warm-up for 2 cycles, i.e., two cycles of a normal pulse of the data strobe signal DQS after its preamble, due to the masking operation by the plurality of mask control signals EN-R0, EN-FO, EN-R1, and EN-F1. Thereafter, normal data D0, D1, D2, ... are sequentially output according to the plurality of transmission clock signals CKR0-TX, CKF0-TX, CKR1-TX, and CKF1-TX.

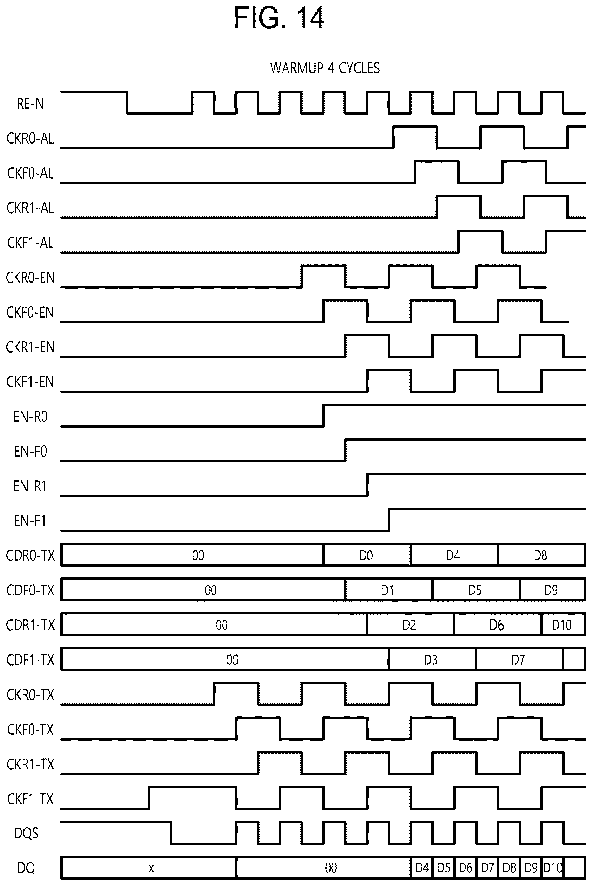

Next, the operation of the data output circuit 100 is described with reference to FIG. 14 for a case where the warm-up information WM<1:0> indicates warm-up for 4 cycles, i.e., '11'.

In the alignment clock generation circuit 140, the switching control signals CONRA and CONFA are generated as '01' and the shift control signal SEL<3:0> is generated as '1000' according to the warm-up information WM<1:0> '11'. In the preliminary mask control signal generation circuit 180, the switching control signals CONRB and CONFB are generated as '00' and the shift control signal SEL<3:0> is generated as '1000' according to the warm-up information WM<1:0> '11'.

According to the switching control signals CONRA and CONFA and the shift control signal SEL<3:0>, the plurality of alignment clock signals CKRO-AL, CKFO-AL, CKR1-AL, and CKF1-AL are generated based on a falling edge of a fifth pulse after a preamble of the external clock signal RE-N.

The read data DATA-RD is latched and aligned according to the plurality of alignment clock signals CKRO-AL, CKFO-AL, CKR1-AL, and CKF1-AL, and the plurality of alignment data DRO-TX, DFO-TX, DR1-TX, and DF1-TX is generated.

According to the switching control signals CONRB and CONFB and the shift control signal SEL<3:0>, the plurality of preliminary mask control signals CKRO-EN, CKF0-EN, CKR1-EN, and CKF1-EN are all maintained at a logic low level and begin pulse generation at a timing earlier than the plurality of alignment clock signals CKRO-AL, CKF0-AL, CKR1-AL, and CKF1-AL. The plurality of preliminary mask control signals CKRO-EN, CKF0-EN, CKR1-EN, and CKF1-EN may be sequentially generated based on a falling edge of a third pulse after the preamble of the external clock signal RE-N.

The plurality of mask control signals EN-R0, EN-FO, EN-R1, and EN-F1 remain at a logic low level and transition to a logic high level according to rising edges of the plurality of preliminary mask control signals CKRO-EN, CKF0-EN, CKR1-EN, and CKF1-EN.

The plurality of masked alignment data CDR0-TX, CDFO-TX, CDR1-TX, and CDF1-TX are masked by the plurality of mask control signals EN-R0, EN-F0, EN-R1, and EN-F1 at a logic low level and are maintained at '00' regardless or independent of the plurality of alignment data DRO-TX, DFO-TX, DR1-TX, and DF1-TX.

Subsequently, as the plurality of mask control signals EN-R0, EN-FO, EN-R1, and EN-F1 transition to a logic high level, the plurality of masked alignment data CDR0-TX, CDFO-TX, CDR1-TX, and CDF1-TX are generated as values D0, D1, D2, and D3 corresponding to the plurality of alignment data DRO-TX, DFO-TX, DR1-TX, and DF1-TX, respectively.

The transmission data DQ and the data strobe signal DQS are generated according to the plurality of transmission clock signals CKR0-TX, CKF0-TX, CKR1-TX, and CKF1-TX, which are generated to match the switching control signals CONRA and CONFA.

The transmission data DQ remains at a logic low level for a duration corresponding to warm-up for 4 cycles, i.e., four cycles of a normal pulse of the data strobe signal DQS after its preamble, due to the masking operation by the plurality of mask control signals EN-R0, EN-FO, EN-R1, and EN-F1. Thereafter, normal data D0, D1, D2, ... are sequentially output according to the plurality of transmission clock signals CKR0-TX, CKF0-TX, CKR1-TX, and CKF1-TX.

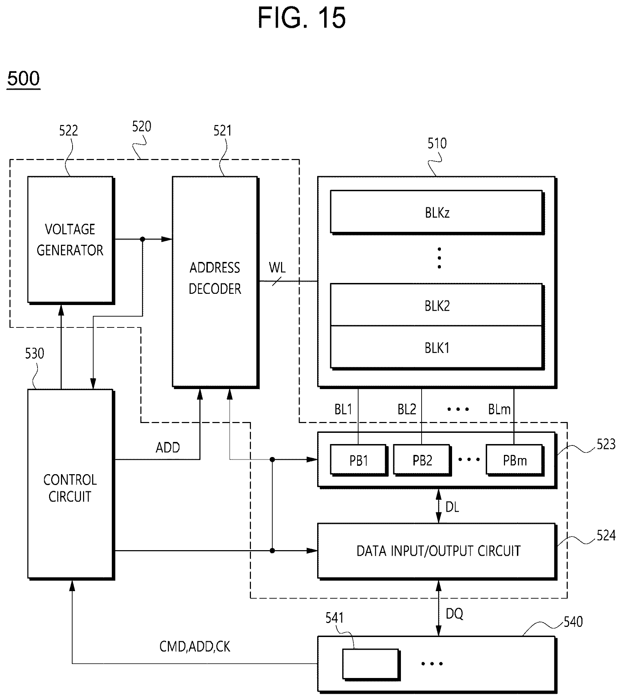

FIG. 15 is a diagram illustrating a configuration of a semiconductor memory apparatus 500, according to an embodiment of the present disclosure.

Referring to FIG. 15, the semiconductor memory apparatus 500 may include a memory cell array 510, a peripheral circuit 520, a control circuit 530, and an input/output pad circuit 540.

The peripheral circuit 520 may include an address decoder 521, a voltage generator 522, a read/write circuit 523, and a data input/output circuit 524.

The input/output pad circuit 540 may include a plurality of pads 541 to receive a command CMD, an address ADD, and a clock signal CK and to transmit and receive data DQ and a data strobe signal. The clock signal CK may include the external clock signal RE-N.

The memory cell array 510 may be coupled to the address decoder 521 through wordlines WL, and to the read/write circuit 523 through bitlines BL1 to BLm. The memory cell array 510 may include a plurality of memory blocks BLK1 to BLKz. The plurality of memory blocks BLK1 to BLKz may be coupled to the address decoder 521 through the wordlines WL and to the read/write circuit 523 through the bitlines BL1 to BLm. Each of the plurality of memory blocks BLK1 to BLKz includes a plurality of memory cells. The memory cells may be nonvolatile memory cells. Each memory block in the memory cell array 510 may include a plurality of pages. Among the memory cells, those coupled to the same wordline may be defined as a page. The plurality of memory blocks BLK1 to BLKz may store normal data, i.e., data that is transmitted and received through a normal read operation and a normal write operation.

Each of the memory cells of the memory cell array 510 may be configured as a single-level cell (SLC) storing one data bit, a multi-level cell (MLC) storing two data bits, a triple-level cell (TLC) storing three data bits, or a quad-level cell (QLC) storing four data bits.

The peripheral circuit 520 may drive the memory cell array 510 to perform a program operation, a read operation, and an erase operation.

The address decoder 521 may be coupled to the memory cell array 510 through the wordlines WL. The address decoder 521 may be configured to operate under the control of the control circuit 530. The address decoder 521 may receive the address ADD from the control circuit 530.

The address decoder 521 may decode a block address from the address ADD. The address decoder 521 may select at least one memory block from among the memory blocks BLK1 to BLKz based on the decoded block address. The address decoder 521 may decode a row address from the received address ADD. Based on the decoded row address, the address decoder 521 may apply voltages provided from the voltage generator 522 to at least one wordline WL to select at least one wordline in the selected memory block.

The address decoder 521 may perform a program operation by applying a program voltage to the selected wordline and a pass voltage lower than the program voltage to unselected wordlines.

The address decoder 521 may perform a read operation by applying a read voltage to the selected wordline and a pass voltage higher than the read voltage to the unselected wordlines.

An erase operation in the semiconductor memory apparatus 500 may be performed on a memory block basis. The address decoder 521 may decode the block address and select one memory block based on the decoded block address. The address decoder 521 may apply a ground voltage to wordlines of the selected memory block and apply an erase voltage to a bulk region in which the selected memory block is formed to perform the erase operation.

The voltage generator 522 may generate various voltages required for operation of the semiconductor memory apparatus 500, such as a read voltage, a pass voltage, a program voltage, and an erase voltage, under the control of the control circuit 530, and may provide the generated voltages to the address decoder 521.

The read/write circuit 523 may include a plurality of page buffers, e.g., page buffers PB1 to PBm. The page buffers PB1 to PBm may be coupled to the memory cell array 510 through first to m-th bitlines BL1 to BLm, respectively. The page buffers PB1 to PBm may operate in response to control signals received from the control circuit 530.

The page buffers PB1 to PBm may perform data communication with the data input/output circuit 524. The page buffers PB1 to PBm may perform a program operation by receiving data to be stored from the data input/output circuit 524 through data lines DL and transmitting the data to the memory cell array 510. The read/write circuit 523 may perform a read operation by reading data from memory cells of a selected page through the bitlines BL and outputting the read data to the data input/output circuit 524. The read/write circuit 523 may perform an erase operation by floating the bitlines BL.

The data input/output circuit 524 may be coupled between the page buffers PB1 to PBm and the input/output pad circuit 540. The data input/output circuit 524 may perform data input and output operations in response to control signals received from the control circuit 530. During a read operation, the data input/output circuit 524 may output data delivered from the memory blocks BLK1 to BLKz through the page buffers PB1 to PBm to an external system of the semiconductor memory apparatus 500 through the input/output pad circuit 540. The external system may be a memory controller, a host, or a test device.

During a write operation, the data input/output circuit 524 may deliver data input from the external system through the input/output pad circuit 540 to the page buffers PB1 to PBm. During a status information read operation, the data input/output circuit 524 may output status information received from the control circuit 530 to the external system through the input/output pad circuit 540.

The data input/output circuit 524 may generate a plurality of mask control signals by adjusting a combination sequence and a shifting value of multi-phase clock signals generated based on an external clock signal according to a warm-up cycle defined by warm-up information. The data input/output circuit 524 may fix transmission data at a predetermined logic level (e.g., a logic low level) for a time corresponding to the warm-up cycle, regardless or independent of read data, based on the plurality of mask control signals. The data input/output circuit 524 may include the data output circuit 100 described with reference to FIG. 7.

The control circuit 530 may be coupled to the address decoder 521, the voltage generator 522, the read/write circuit 523, the data input/output circuit 524, and the input/output pad circuit 540. The control circuit 530 may receive the command CMD, the address ADD, and the clock signal CK through the input/output pad circuit 540.

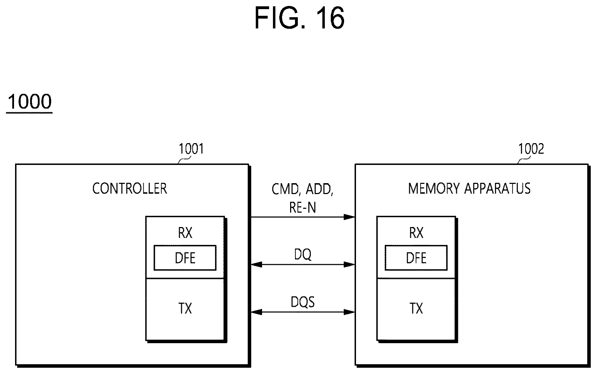

FIG. 16 is a diagram illustrating a configuration of a memory system 1000, according to an embodiment of the present disclosure.

The memory system 1000 may include a controller 1001 and a memory apparatus 1002.

The controller 1001 may provide the command CMD, the address signal ADD, and the clock signal RE-N to the memory apparatus 1002. The controller 1001 may transmit and receive the transmission data DQ and the data strobe signal DQS with the memory apparatus 1002. The controller 1001 may include a receiving circuit RX and a transmitting circuit TX for transmitting and receiving the transmission data DQ and the data strobe signal DQS.

The memory apparatus 1002 may transmit and receive the transmission data DQ and the data strobe signal DQS with the controller 1001. The memory apparatus 1002 may include a receiving circuit RX and a transmitting circuit TX for transmitting and receiving the transmission data DQ and the data strobe signal DQS.

The controller 1001 and the memory apparatus 1002 may transmit the transmission data DQ to each other in accordance with a set warm-up cycle. The receiving circuits RX of the controller 1001 and the memory apparatus 1002 receive the transmission data DQ using a decision feedback equalization (DFE) scheme. To perform signal processing according to the decision feedback equalization scheme, a signal line on which the transmission data DQ is transmitted may be fixed to a predetermined logic level (e.g., a logic low level) during a predefined interval, for example, an interval corresponding to warm-up information. This operation of fixing the signal line on which the transmission data DQ is transmitted to a predetermined logic level (e.g., a logic low level) for the predefined interval may be referred to as a pre-drive operation.

The memory apparatus 1002 may perform the pre-drive operation during the interval corresponding to the warm-up cycle. The memory apparatus 1002 may generate a plurality of mask control signals by adjusting a combination sequence and a shifting value of multi-phase clock signals generated according to the external clock signal, i.e., the clock signal RE-N, based on the warm-up cycle defined by the warm-up information, and may perform the pre-drive operation by fixing the transmission data DQ to a logic low level for an interval corresponding to the warm-up cycle regardless or independent of read data, based on the plurality of mask control signals. The memory apparatus 1002 may include the data output circuit 100 described with reference to FIG. 7.

Concepts are disclosed in conjunction with examples and embodiments. Those skilled in the art will understand that various modifications, additions, combinations, and/or substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A data output circuit, comprising:
a transmission clock generation circuit configured to receive warm-up information and an external clock signal and configured to output a plurality of transmission clock signals, wherein the warm-up information indicates a number of cycles included in a warm-up cycle operation;
a data alignment circuit configured to receive read data, the external clock signal, and the warm-up information and configured to output a plurality of alignment data;
a transmission circuit configured to receive the plurality of transmission clock signals and a plurality of masked alignment data and configured to output transmission data and a data strobe signal; and
a data output control circuit configured to fix the plurality of masked alignment data to a predetermined logic level during a time interval corresponding to the warm-up cycle by controlling the plurality of alignment data using a plurality of mask control signals generated according to the external clock signal and the warm-up information.

2. The data output circuit of claim 1, wherein the data output control circuit is configured to fix the plurality of masked alignment data to the predetermined logic level during a cycle time of at least one pulse corresponding to the number of the warm-up cycles among pulses of the data strobe signal.

3. The data output circuit of claim 1, wherein the transmission clock generation circuit comprises:
a dividing circuit configured to divide the external clock signal to generate multi-phase clock signals;
a first clock control circuit configured to receive a first switching control signal and, from among the multi-phase clock signals, a first phase clock signal and a third phase clock signal, and configured to output, from among the plurality of transmission clock signals, a first transmission clock signal and a third transmission clock signal;
a second clock control circuit configured to receive a second switching control signal and, from among the multi-phase clock signals, a second phase clock signal and a fourth phase clock signal, and configured to output, from among the plurality of transmission clock signals, a second transmission clock signal and a fourth transmission clock signal; and
a switching control signal generation circuit configured to receive the warm-up information and configured to output the first switching control signal and the second switching control signal.

4. The data output circuit of claim 1, wherein the data alignment circuit comprises:
an alignment clock generation circuit configured to receive the external clock signal and the warm-up information and configured to output a plurality of alignment clock signals; and
a pipe latch circuit configured to deserialize the read data to generate deserialized data, configured to latch the deserialized data according to the plurality of alignment clock signals, and configured to output the latched signals as the plurality of alignment data.

5. The data output circuit of claim 1, wherein the transmission circuit comprises:
a first driving circuit configured to generate the transmission data by pulling up a first output node to a power supply voltage level or pulling down the first output node to a ground voltage level based on a logic level of each of the plurality of alignment data at a rising edge timing of each of the plurality of transmission clock signals; and
a second driving circuit configured to generate the data strobe signal by pulling up a second output node to the power supply voltage level or pulling down the second output node to the ground voltage level at a rising edge timing of each of the plurality of transmission clock signals.

6. The data output circuit of claim 1, wherein the data output control circuit comprises:
a preliminary mask control signal generation circuit configured to generate a plurality of preliminary mask control signals by adjusting a combination order and a shifting value of multi-phase clock signals generated according to the external clock signal based on the warm-up information;
a mask control signal generation circuit configured to latch a power supply voltage according to the plurality of preliminary mask control signals and generate latched signals, and configured to output the latched signals as the plurality of mask control signals; and
a data mask circuit configured to fix the plurality of masked alignment data to the predetermined logic level by masking the plurality of alignment data according to the plurality of mask control signals.

7. The data output circuit of claim 6, wherein the preliminary mask control signal generation circuit comprises:
a dividing circuit configured to divide the external clock signal to generate multi-phase clock signals;
a first clock control circuit configured to switch signal paths of a first phase clock signal and a third phase clock signal from among the multi-phase clock signals according to a first switching control signal, configured to generate a plurality of first shifting signals and a plurality of second shifting signals by shifting each of the switched signals, and configured to select one from each of the plurality of first shifting signals and the plurality of second shifting signals according to a shift control signal to generate a first preliminary mask control signal and a third preliminary mask control signal from among the plurality of preliminary mask control signals;
a second clock control circuit configured to switch signal paths of a second phase clock signal and a fourth phase clock signal from among the multi-phase clock signals according to a second switching control signal, configured to generate a plurality of third shifting signals and a plurality of fourth shifting signals by shifting each of the switched signals, and configured to select one from each of the plurality of third shifting signals and the plurality of fourth shifting signals according to the shift control signal to generate a second preliminary mask control signal and a fourth preliminary mask control signal from among the plurality of preliminary mask control signals;
a switching control signal generation circuit configured to receive the warm-up information and configured to generate the first switching control signal and the second switching control signal; and
a shift control signal generation circuit configured to receive the warm-up information and configured to generate the shift control signal.

8. A semiconductor memory apparatus, comprising:
a memory cell array;
an input/output pad circuit including a plurality of pads configured to receive a command, an address, and an external clock signal, and configured to receive and output transmission data and a data strobe signal;
a plurality of page buffers coupled to the memory cell array; and
a data input/output circuit coupled between the plurality of page buffers and the input/output pad circuit, the data input/output circuit configured to generate a plurality of mask control signals by combining and shifting multi-phase clock signals, which are generated based on the external clock signal, in different sequences according to a warm-up cycle defined by warm-up information, and configured to fix the transmission data to a predetermined logic level independent of read data during a time interval corresponding to the warm-up cycle according to the plurality of mask control signals.

9. The semiconductor memory apparatus of claim 8, wherein the data input/output circuit is configured to fix the transmission data to the predetermined logic level during a cycle time of at least one pulse corresponding to the number of the warm-up cycles among pulses of the data strobe signal.

10. The semiconductor memory apparatus of claim 8, wherein the data input/output circuit comprises:
a transmission clock generation circuit configured to receive the warm-up information and the external clock signal and configured to output a plurality of transmission clock signals;
a data alignment circuit configured to receive read data output from the memory cell array, the external clock signal, and the warm-up information and configured to output a plurality of alignment data;
a transmission circuit configured to receive the plurality of transmission clock signals and a plurality of masked alignment data and configured to output the transmission data and the data strobe signal; and
a data output control circuit configured to fix the plurality of masked alignment data to the predetermined logic level during a time interval corresponding to the warm-up cycle by controlling the plurality of alignment data using the plurality of mask control signals generated according to the external clock signal and the warm-up information.

11. The semiconductor memory apparatus of claim 10, wherein the transmission clock generation circuit comprises:
a dividing circuit configured to divide the external clock signal to generate the multi-phase clock signals;
a first clock control circuit configured to receive a first switching control signal and, from among the multi-phase clock signals, a first phase clock signal and a third phase clock signal, and configured to output, from among the plurality of transmission clock signals, a first transmission clock signal and a third transmission clock signal;
a second clock control circuit configured to receive a second switching control signal and, from among the multi-phase clock signals, a second phase clock signal and a fourth phase clock signal, and configured to output, from among the plurality of transmission clock signals, a second transmission clock signal and a fourth transmission clock signal; and
a switching control signal generation circuit configured to receive the warm-up information and configured to output the first switching control signal and the second switching control signal.

12. The semiconductor memory apparatus of claim 10, wherein the data alignment circuit comprises:
an alignment clock generation circuit configured to receive the external clock signal and the warm-up information and configured to output a plurality of alignment clock signals; and
a pipe latch circuit configured to deserialize the read data to generate deserialized data, configured to latch the deserialized data according to the plurality of alignment clock signals, and configured to output the latched signals as the plurality of alignment data.

13. The semiconductor memory apparatus of claim 10, wherein the transmission circuit comprises:
a first driving circuit configured to generate the transmission data by pulling up a first output node to a power supply voltage level or pulling down the first output node to a ground voltage level based on a logic level of each of the plurality of alignment data at a rising edge timing of each of the plurality of transmission clock signals; and
a second driving circuit configured to generate the data strobe signal by pulling up a second output node to the power supply voltage level or pulling down the second output node to the ground voltage level at a rising edge timing of each of the plurality of transmission clock signals.

14. The semiconductor memory apparatus of claim 10, wherein the data output control circuit comprises:
a preliminary mask control signal generation circuit configured to generate a plurality of preliminary mask control signals by adjusting a combination order and a shifting value of the multi-phase clock signals generated according to the external clock signal based on the warm-up information;
a mask control signal generation circuit configured to latch a power supply voltage according to the plurality of preliminary mask control signals and generate latched signals, and configured to output the latched signals as the plurality of mask control signals; and
a data mask circuit configured to fix the plurality of masked alignment data to the predetermined logic level by masking the plurality of alignment data according to the plurality of mask control signals.

15. A memory system, comprising:
a semiconductor memory apparatus including a first receiving circuit configured to operate in a decision feedback equalization scheme and to output transmission data and a data strobe signal according to a read command; and
a controller including a second receiving circuit configured to operate in the decision feedback equalization scheme and to provide an external clock signal and the read command to the semiconductor memory apparatus,
wherein the semiconductor memory apparatus is configured to generate read data according to the read command, configured to generate a plurality of mask control signals by combining and shifting multi-phase clock signals, which are generated according to the external clock signal, in different sequences based on a warm-up cycle defined by warm-up information, and configured to fix the transmission data to a predetermined logic level independent of the read data during a time interval corresponding to the warm-up cycle according to the plurality of mask control signals.

16. The memory system of claim 15, wherein the semiconductor memory apparatus is configured to fix the transmission data to the predetermined logic level during a cycle time of at least one pulse corresponding to the number of the warm-up cycles among pulses of the data strobe signal.

17. The memory system of claim 15, wherein the semiconductor memory apparatus comprises:
a transmission clock generation circuit configured to receive the warm-up information and the external clock signal and configured to output a plurality of transmission clock signals;
a data alignment circuit configured to receive the read data, the external clock signal, and the warm-up information and configured to output a plurality of alignment data;
a transmission circuit configured to receive the plurality of transmission clock signals and a plurality of masked alignment data and configured to output the transmission data and the data strobe signal; and
a data output control circuit configured to fix the plurality of masked alignment data to the predetermined logic level during a time interval corresponding to the warm-up cycle by controlling the plurality of alignment data using the plurality of mask control signals.

18. The memory system of claim 17, wherein the data output control circuit comprises:
a preliminary mask control signal generation circuit configured to generate a plurality of preliminary mask control signals by adjusting a combination order and a shifting value of the multi-phase clock signals generated according to the external clock signal based on the warm-up information;
a mask control signal generation circuit configured to latch a power supply voltage according to the plurality of preliminary mask control signals and generate latched signals, and configured to output the latched signals as the plurality of mask control signals; and
a data mask circuit configured to fix the plurality of masked alignment data to the predetermined logic level by masking the plurality of alignment data according to the plurality of mask control signals.
